Europäisches Patentamt

European Patent Office

Office européen des brevets

(19)

(11) Veröffentlichungsnummer: **0 432 488 A2**

## (12) EUROPÄISCHE PATENTANMELDUNG

(21) Anmeldenummer: 90121731.5

(22) Anmeldetag: 13.11.90

(51) Int. Cl.⁵ **H01J 37/32**

(30) Priorität: 12.12.89 DE 3941053

(43) Veröffentlichungstag der Anmeldung:
**19.06.91 Patentblatt 91/25**

(84) Benannte Vertragsstaaten:
**DE FR GB IT**

(71) Anmelder: **Siemens Aktiengesellschaft**
**Wittelsbacherplatz 2**
**W-8000 München 2(DE)**

(72) Erfinder: **Hübner, Holger, Dr.**
**Hamsterweg 10**
**W-8011 Baldham(DE)**

(54) **Anordnung zur Durchführung von Plasmaprozessen an einer Halbleiterscheibe und Betriebsverfahren für eine solche Anordnung.**

(57) Es ist eine Reaktionskammer (11) vorgesehen mit einem Gaseinlaß (12), einem Pumpstutzen (13) und einer über einen Koppelkondensator (17) mit einer Hochfrequenz (HF)-Wechselspannungsquelle (18) zur Erzeugung eines Plasmas (111) verbundenen Elektrode (14), auf der im Betrieb die Halbleiterscheibe (15) liegt. Es sind Mittel vorgesehen, mit denen beim Abschalten der HF-Wechselspannungsquelle (18) ein statisches elektrisches Feld erzeugt wird, in dem negativ geladene Teilchen von dem Ort der Halbleiterscheibe (15) weggelenkt werden. Das statische elektrische Feld wird insbesondere durch eine Hilfselektrode (112) erzeugt, die seitlich oberhalb der Elektrode (14) angeordnet ist. Die Anordnung und das Betriebsverfahren dafür ist anwendbar in der Herstellung integrierter Schaltungen in der Halbleitertechnologie.

FIG 1

EP 0 432 488 A2

Anordnung zur Durchführung von Plasmaprozessen an einer Halbleiterscheibe und Betriebsverfahren für eine solche Anordnung

Die Erfindung betrifft eine Anordnung zur Durchführung von Plasmaprozessen an einer Halbleiterscheibe sowie ein Betriebsverfahren für eine Anordnung zur Durchführung von Plasmaprozessen an einer Halbleiterscheibe.

Aus z. B. S.M. Sze, VLSI-Technologie, Mc Graw-Hill New York, 1988, S. 216 Fig. 23 ist eine Anordnung zur Durchführung von Plasmaprozessen an Halbleiterscheiben bekannt. Eine solche Anordnung enthält eine Reaktionskammer, die mindestens mit einem Gaseinlaß und einen Pumpstutzen versehen ist. Ferner enthält die Reaktionskammer eine Elektrode, die über einen Koppelkondensator mit einer Hochfrequenz (HF)-Wechselspannungsquelle zur Erzeugung eines Plasmas zwischen der Elektrode und der geerdeten Kammerwand verbunden ist. Auf der Elektrode liegt im Betrieb die Halbleiterscheibe.

Bei Plasmaprozessen wie z. B. Ätzen oder Abscheiden ist das Plasma infolge der größeren Beweglichkeit der negativen Ladungsträger (Elektronen) im Vergleich zu den positiven Ladungsträgern(Schwere Ionen) positiver als die das Plasma begrenzenden Kammerwände und als die Elektrode. Zwischen dem Plasma und der auf der Elektrode liegenden Halbleiterscheibe bildet sich ein sogenannter Dunkelraum aus. Über dem Dunkelraum liegt eine Spannung von einigen 10 bis einigen 100 Volt. Durch diese Spannung werden positive Ionen aus dem Plasma abgezogen und auf die Halbleiterscheibe hin beschleunigt. Umgekehrt können negative Ladungsträger aufgrund dieser Potentialdifferenz nicht zur Halbleiterscheibe gelangen. Die negativen Ladungsträger bleiben am Rand des Dunkelraumes quasi stationär lokalisiert. Dieser Effekt wirkt sich besonders stark aus, wenn die Halbleiterscheibe in der Reaktionskammer unten liegt.

Die negativen Ladungsträger bilden Keime für sich bildende Partikel. Bei Silizium-enthaltenden Plasmen können diese Partikel bis zu einer Größe von 1 μm heranwachsen. Aufgrund ihrer hohen negativen Ladung (bis zu 2000 Elektronen durch Elektroneneinfang) und aufgrund des elektrischen Feldes im Dunkelraum bleiben diese an der Obergrenze des Dunkelraumes lokalisiert. Beim Abschalten der Anlage können sie jedoch auf die Halbleiterscheibe gelangen und Kontaminationen verursachen.

Dieses Problem ist bisher ungelöst. Durch eine Änderung der Anordnung der Halbleiterscheibe, in der Reaktionskammer oben oder an den senkrechten Wänden, ist das Problem nicht zu lösen, da die Gravitationskräfte gegenüber den elektrostatischen Kräften keinen Einfluß haben und die Bewegung der Partikel durch kleinste Restfelder beeinflußt wird.

Der Erfindung liegt daher die Aufgabe zugrunde, eine Anordnung zur Durchführung von Plasmaprozessen an einer Halbleiterscheibe anzugeben, mit der Kontaminationen der Halbleiterscheibe beim Abschalten der Anlage in Folge von an der Grenzfläche zwischen dem Dunkelraum und der Plasmasäule lokalisierten, negativen Ladungsträgern vermieden wird, sowie ein Betriebsverfahren für eine solche Anordnung anzugeben.

Diese Aufgabe wird erfindungsgemäß gelöst durch eine Anordnung zur Durchführung von Plasmaprozessen an einer Halbleiterscheibe mit folgenden Merkmalen:

a) es ist eine Reaktionskammer vorgesehen mit einem Gaseinlaß, einem Pumpstutzen, einer über einen Koppelkondensator mit einer HF-Wechselspannungsquelle zur Erzeugung eines Plasmas verbundenen Elektrode und einer Halterung, auf der im Betrieb die Halbleiterscheibe liegt,

b) es sind Mittel vorgesehen, mit denen beim Abschalten der HF-Wechselspannungsquelle ein statisches elektrisches Feld erzeugt wird, in dem negativ geladene Teilchen von dem Ort der Halbleiterscheibe weggelenkt werden.

Es liegt im Rahmen der Erfindung, das statische elektrische Feld durch eine Hilfselektrode zu erzeugen. Die Hilfselektrode wird über einen Schalter wahlweise mit dem Erdpotential oder mit einer eine postive Spannung liefernden Gleichspannungsquelle verbunden. Die Hilfselektrode ist seitlich oberhalb der Elektrode angeordnet. Die Hilfselektrode ist so angeordnet, daß es einen geradlinigen Sichtkontakt zwischen der Hilfselektrode und dem Bereich gibt, in dem sich bei Betrieb der HF-Wechselspannugsquelle ein Dunkelraum zwischen dem Plasma und der Elektrode bildet. Im Betrieb der Anordnung, d. h. wenn die HF-Wechselspannungsquelle eingeschaltet ist, ist die Hilfselektrode mit dem Erdpotential verbunden. Beim Abschalten der HF-Wechselspannungsquelle wird die Hilfselektrode mit der Gleichspannungsquelle verbunden, so daß an der Hilfselektrode ein positives Potential anliegt. Dieses positive Potential saugt die negativen Ladungsträger ab, so daß sie nicht zur Halbleiterscheibe gelangen können. Das positive Potential muß aber so bemessen werden, daß das Plasma erlöschen kann.

Eine Ausführungsform der Hilfselektrode, in der die Hilfselektrode den Dunkelraum ringförmig umgibt, sorgt für eine schnelle effektive Absaugung der negativen Ladungsträger.

Es liegt im Rahmen der Erfindung, das statische elektrische Feld dadurch zu erzeugen, daß die Halterung, auf der im Betrieb die Halbleiterscheibe liegt, über einen Schalter mit einer eine negative Spannung liefernden Gleichspannungsquelle verbunden werden kann. Beim Abschalten der HF-Wechselspannungsquelle wird dann die Halterung auf ein negatives Potential gelegt. In vielen Anordnungen zur Durchführung von Plasmaprozessen ist die Halterung mit der HF- führenden Elektrode verbunden, sie ist insbesondere auf der Elektrode vorgesehen. In diesem Fall wird zwischen der Elektrode und dem Koppelkondensator ein Schalter vorgesehen, über den die Elektrode wahlweise mit der HF-Wechselspannungsquelle oder mit einer negative Spannung liefernden Gleichspannungsquelle verbunden wird. In dieser Anordnung wird beim Abschalten der HF-Wechselspannungsquelle die Elektrode auf ein negatives Potential gelegt. Dabei werden die negativen Ladungsträger durch das negative Potential der Halterung bzw. der Elektrode abgestoßen. Das negative Potential muß so groß gewählt werden, daß einerseits eine effektive Abstoßung der negativen Ladungsträger vom Ort der Halbleiterscheibe gewährleistet ist, daß aber andererseits das Plasma erlöschen kann. Die negativen Ladungsträger rekombinieren in diesem Fall an den Kammerwänden. Diese Anordnung hat den Vorteil, daß zu ihrer Realisierung nur geringe Eingriffe an bestehenden Anordnungen vorgenommen zu werden brauchen.

Die erfindungsgemäße Aufgabe wird ferner gelöst durch ein Betriebsverfahren für eine Anordnung zur Durchführung von Plasmaprozessen an einer Halbleiterscheibe mit folgendem Schritt: beim Abschalten einer ein Plasma erzeugenden HF-Wechselspannungsquelle wird ein statisches elektrisches Feld erzeugt, das eine Bewegung von negativ geladenen Teilchen in Richtung auf den Ort der Halbleiterscheibe verhindert.

Weitere Ausgestaltungen der Erfindung gehen aus den übrigen Ansprüchen hervor.

Im folgenden wird die Erfindung anhand von Ausführungsbeispielen und der Figuren näher erläutert.

In Fig. 1 ist eine erfindungsgemäße Anordnung mit einer Hilfselektrode dargestellt.

In Fig. 2 ist eine erfindungsgemäße Anordnung mit einer zusätzlichen Gleichspannungsquelle für die Elektrode dargestellt.

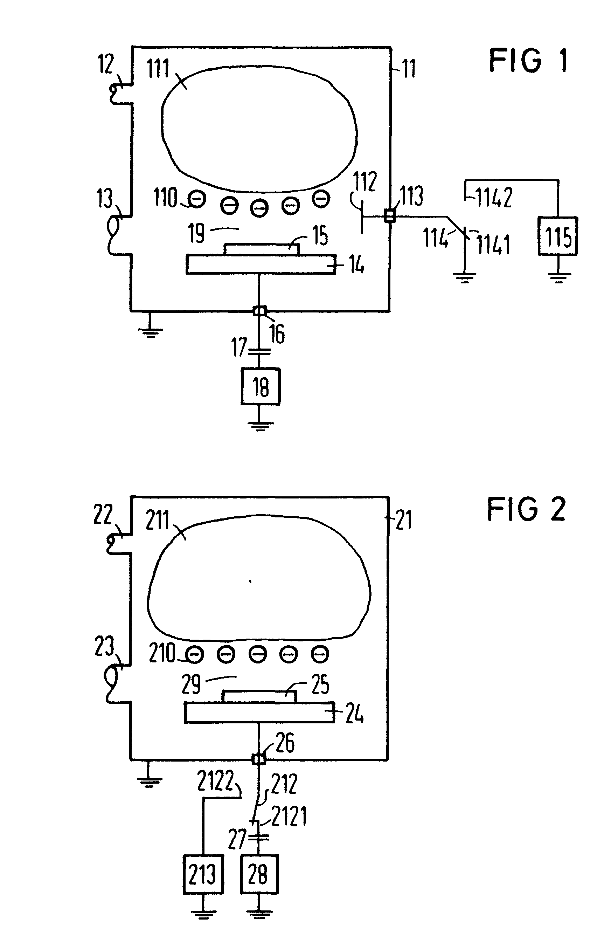

In Fig. 1 ist eine Reaktionskammer 11 dargestellt. Die Reaktionskammer 11 weist einen Gaseinlaß 12 und einen Pumpstutzen 13 auf. Durch den Gaseinlaß 12 wird die Reaktionskammer 11 mit Reaktionsgas, z. B. $CL_2$, beschickt. Die Anordnung wird im Gasdurchfluß betrieben bei einem Druck im Bereich von etwa 0,1 ... 100 Pa. Der Pumpstutzen 13 ist so dimensioniert, daß eine genügende Pumpleistung zum Aufrecht erhalten des Unterdrucks zur Verfügung steht.

In der Reaktionskammer 11 ist ferner eine Elektrode 14 vorgesehen, die in diesem Beispiel gleichzeitig als Halterung für eine Halbleiterscheibe 15 dient. Die Elektrode 14 ist über eine Vakuumdurchführung 16 und einen Koppelkondensator 17 mit einer HF-Wechselspannungsquelle 18 verbunden. Im Betrieb der Anordnung wird die Halbleiterscheibe 15, an der Plasmaprozesse durchgeführt werden sollen, auf die Elektrode 14 gelegt. Bei eingeschalteter HF-Wechselspannungsquelle 18 bildet sich in der Reaktionskammer ein Plasma 111 aus. Wegen der unterschiedlichen Beweglichkeiten positiver und negativer Ladungsträger bildet sich zwischen der Elektrode 14, auf der die Halbleiterscheibe 15 liegt und dem Plasma 111 ein Dunkelraum 19 aus. Da das Plasma 111 positiver ist als die Wände der Reaktionskammer 11. stellt sich in Gleichgewicht an der Elektrode 14 eine Spannung von z. B. etwa -10 ... -100 Volt ein. Die Folge ist, daß negative Ladungsträger sich an der Grenzschicht zwischen dem Plasma 111 und dem Dunkelraum 19 lokalisieren. Diese negativen Ladungsträger bilden Keime für sich bildende Partikel 110. die ebenfalls negativ geladen sind und ebenfalls an der Grenzfläche zwischen dem Plasma 111 und dem Dunkelraum 19 lokalisiert sind. Beim Abschalten der HF-Wechselspannungsquelle 18 liegt die Elektrode 14 wieder auf Erdpotential, so daß die Partikel 110 sich ungehindert in Richtung auf die Halbleiterscheibe 15 bewegen können. Um dieses zu vermeiden, ist in der Reaktionskammer 11 eine Hilfselektrode 112 angeordnet. Die Hilfselektrode 112 ist seitlich oberhalb der Elektrode 14 so angeordnet, daß sie seitlich dem Dunkelraum 19 gegenüberliegt. Die Hilfselektrode 112 ist über eine Durchführung 113 und einen Schalter 114 wahlweise mit dem Erdpotential oder einer Gleichspannungsquelle 115 verbunden. Im Betrieb der Anlage, wenn die HF-Wechselspannungsquelle 18 eingeschaltet ist, wird der Schalter 114 in eine erste Schalterstellung 1141 gebracht. Damit ist die Hilfselektrode 112 geerdet. Beim Abschalten der HF-Wechselspannungsquelle 18 wird der Schalter 114 in eine zweite Schalterstellung 1142 gebracht.

Damit ist die Hilfselekrode 112 mit der Gleichspannungsquelle 115 verbunden, die eine positive Spannung liefert. Da die Hilfselektrode 112 auf einem positiven Potential liegt, werden die Partikel 110, die stark negativ geladen sind, zu der Hilfselektrode 112 beschleunigt und können nicht auf die Halbleiterscheibe 15 gelangen. Diese Anordnung und dieses Betriebsverfahren verhindern wirkungsvoll eine Kontamination der Halbleiterscheibe 15 durch gebildete Partikel 110.

In Fig. 2 ist eine weitere Ausführungsform der Erfindung dargestellt. Es ist eine Reaktionskammer 21 mit einem Gaseinlaß 22 und einem Pumpstutzen 23 dargestellt, die analog zu den entsprechenden Merkmalen des ersten Ausführungsbeispiels aufgebaut sind und betrieben werden. In der Reaktionskammer 21 ist eine Elektrode 24 angeordnet, die gleichzeitig zur Halterung einer Halbleiterscheibe 25 dient. Die Elektrode 24 ist über eine Durchführung 26 mit einem Schalter 212 verbunden, der eine erste Schalterstellung 2121 und eine zweite Schalterstellung 2122 aufweist. Über die erste Schalterstellung 2121 ist der Schalter 212 über einen Koppelkondensator 27 mit einer HF-Wechselspannungsquelle 28 verbunden. Über die zweite Schalterstellung 2122 ist der Schalter 212 mit einer Gleichspannungsquelle 213 verbunden. Im Betrieb der Anordnung liegt die Halbleiterscheibe 25 auf der Elektrode 24. In der Schalterstellung 2121 des Schalters 212 und bei eingeschalteter HF-Wechselspannungsquelle 28 bildet sich in der Reaktionskammer 21 ein Plasma 211 aus. Wie oben erläutert, bildet sich zwischen dem Plasma 211 und der Elektrode 27 ein Dunkelraum 29 aus. An der Grenzfläche zwischen dem Dunkelraum 29 und dem Plasma 211 bilden sich auch hier negativ geladene Partikel 210. Um zu verhindern, daß diese negativ geladenen Partikel 210 beim Abschalten der HF-Wechselspannungsquelle 28 auf die Halbleiterscheibe 25 gelangen, wird die Elektrode 24 beim Abschalten der HF-Wechselspannungsquelle 28 durch Umlegen des Schalters 212 in die zweite Schalterstellung 2122 mit der Gleichspannungsquelle 213 verbunden, die eine große negative Spannung erzeugt. Die negative Spannung darf höchstens so groß sein, daß das Plasma gerade erlischt. In dieser Ausführungsform der Erfindung wird das negative Potential an der Elektrode 24 auch beim Abschalten der HF-Wechselspannungsquelle 28, d. h. beim Löschen des Plasmas 211, aufrecht erhalten. Die Partikel 210 werden weiterhin durch das negative Potential der Elektrode 24 von der Halbleiterscheibe 25 ferngehalten. Da das Plasma 211 erloschen ist, bewegen sich die Partikel 210 in Richtung auf die Wände der Reaktionskammer 21, wo sie rekombinieren.

Diese Ausführungsform der Erfindung ist zwar eventuell etwas weniger effektiv als die erste Ausführungsform der Erfindung, da hier die Partikel 210 nur von der Elektrode ferngehalten werden und nicht, wie in der ersten Ausführungsform, gezielt abgesaugt werden. Diese zweite Ausführungsform hat jedoch gegenüber der ersten Auführungsform den Vorteil, daß sie durch geringe Eingriffe an einer bekannten, eventuell vorhandenen Anordnung realisiert wird.

In beiden beschriebenen Ausführungsformen dient die HF-führende Elektrode gleichzeitig als Halterung für die Halbleiterscheibe. Die Erfindung läßt sich jedoch ohne weiteres auch auf solche Anordnungen zur Durchführung von Plasmaprozessen übertragen, in deren eine separate Halterung für die Halbleiterscheibe vorgesehen ist, wie z. B. bei den ECR (Electron Cyclotron Resonanz)-Anla-

gen.

## Ansprüche

1. Anordnung zur Durchführung von Plasmaprozessen an einer Halbleiterscheibe mit folgenden Merkmalen:
   a) es ist eine Reaktionskammer (11, 21) vorgesehen mit einem Gaseinlaß (12, 22), einem Pumpstutzen (13, 23), einer über einen Koppelkondensator (17, 27) mit einer Hochfrequenz (HF)-Wechselspannungsquelle (18, 28) zur Erzeugung eines Plasmas (111, 211) verbundenen Elektrode (14, 24) und einer Halterung (14, 24), auf der im Betrieb die Halbleiterscheibe (15, 25) liegt.
   b) es sind Mittel vorgesehen, mit denen beim Abscheiden der HF-Wechselspannungsquelle (18, 28) ein statisches elektrisches Feld erzeugt wird, in dem negativ geladene Teilchen von dem Ort der Halbleiterscheibe (15, 25) weggelenkt werden.

2. Anordnung nach Anspruch 1, **dadurch gekennzeichnet**, daß die Halterung (14, 24) mit der Elektrode (14, 24) fest verbunden ist.

3. Anordnung nach Anspruch 1 oder 2, **gekennzeichnet durch** folgende Merkmale:
   a) die Mittel zur Erzeugung des statischen elektrischen Feldes bestehen in einer Hilfselektrode (112), die über einen Schalter (114) wahlweise mit dem Erdpotential oder mit einer eine positive Spannung liefernden Gleichspannungsquelle (115) verbunden wird,
   b) die Hilfselektrode (112) ist seitlich oberhalb der Elektrode (14) so angeordnet, daß es einen geradlinigen Sichtkontakt zwischen der Hilfselektrode (112) und dem Bereich gibt, in dem sich bei Betrieb der HF-Wechselspannungsquelle (18) ein Dunkelraum (19) zwischen dem Plasma (111) und der Elektrode (14) bildet.

4. Anordnung nach Anspruch 3, **dadurch gekennzeichnet**, daß die Hilfselektrode (112) den Dunkelraum (19) ringförmig umgibt.

5. Anordnung nach Anspruch 1 oder 2, **dadurch gekennzeichnet**, daß die Mittel zur Erzeugung des statischen elektrischen Feldes darin bestehen, daß eine eine negative Spannung liefernde Gleichspannungsquelle (213) und ein Schalter (212) vorgesehen sind, über den die Halterung (24) mit der eine negative Spannung liefernden Gleichspannungquelle (213) beim Abschalten der HF-Wechselspannungsquelle (28) verbunden wird.

6. Betriebsverfahren für eine Anordnung zur Durchführung von Plasmaprozessen an einer Halbleiterscheibe mit dem folgenden Schritt: beim Abschalten einer ein Plasma (111, 211) erzeugenden HF-Wechselspannungsquelle (18, 28) wird ein statisches elektrisches Feld erzeugt, das eine Bewegung von negativ geladenen Teilchen in Richtung auf den Ort der Halbleiterscheibe verhindert.

7. Betriebsverfahren nach Anspruch 6 mit folgenden Schritten:
   a) während die HF-Wechselspannungsquelle (18) eingeschaltet ist, ist eine Hilfselektrode (112), die seitlich oberhalb einer Elektrode (14), die über einen Koppelkondensator (13) mit der HF-Wechselspannungsquelle (18) verbunden ist, im Bereich eines sich zwischen Elektrode (14) und Plasma (111) bildenden Dunkelraums (19) angeordnet ist und die über einen Schalter (114) wahlweise mit dem Erdpotential oder mit einer eine positive Spannung liefernden Gleichspannungsquelle (115) verbunden ist, mit dem Erdpotential verbunden,
   b) beim Abschalten der HF-Wechselspannungsquelle (18) wird die Hilfselektrode (112) mit der eine positive Spannung liefernden Gleichspannungsquelle (115) verbunden.

8. Betriebsverfahren nach Anspruch 6 mit folgendem Schritt: beim Abschalten der HF-Wechselspannungsquelle (28) wird eine Halterung (24), auf der die Halbleiterscheibe (25) im Betrieb liegt, mit Hilfe eines Schalters (212) mit einer eine negative Spannung liefernden Gleichspannungsquelle (213) verbunden.

9. Betriebsverfahren nach Anspruch 6 mit folgendem Schritt: beim Abschalten der HF-Wechselspannungsquelle (28) wird eine Elektrode (24), die über einen Koppelkondensator (27) mit der HF-Wechselspannungsquelle (28) verbunden ist und auf der die Halbleiterscheibe (25) im Betrieb liegt, mit Hilfe eines zwischen die Elektrode (24) und den Koppelkondensator (27) geschalteten Schalters (212) mit einer eine negative Spannung liefernden Gleichspannungsquelle (213) verbunden.

FIG 1

FIG 2